# EUROPEAN PATENT APPLICATION

(11) **EP 1 939 689 A1**
(43) Date of publication of application: **02.07.2008**
(21) Application number: 06026991.7
(22) Date of filing: 28.12.2006
(51) Int. Cl.: G03F 7/20

(54) **Immersion fluid and method for producing microchips**

(71) Applicant: DSM IP Assets B.V., 6411 TE Heerlen (NL)
(72) Inventor: Jahromi, Shahab, 6211 PA Maastricht (NL); Bremer, Leonardus Gerardus Bernardus, 4600 Vise (BE)
(74) Representative: van der Ploeg, Antonius Franciscus M.J.

(57) **Abstract**

Method for producing microchips by using immersion lithography, wherein the immersion fluid comprises particles with a size at about 9 nm or less, and about 1 nm or more of a metal oxide, nitride or fluoride, wherein the particles have a functionalized surface. The exposure light in the method has improved resolution, so that microchips having an increased integration density are obtained.

## Description

The invention relates to an immersion fluid suitable for producing microchips by using immersion lithography, a method of producing microchips and a method for producing nanosized particles suitable for immersion lithography.

Since the invention of integrated circuits in 1959, the computing power of microprocessors has been doubled every 18 months and every three years a new generation of microchips has been introduced, every time reducing the size of electronic devices. This phenomenon is known as Moore's law. The performance of the microchip is, to a large degree, governed by the size of the individual circuit elements, such as for example copper and aluminium lines, in the microchip. A microchip in general comprises a complex three-dimensional structure of alternating, patterned layers of conductors, dielectrics, and semiconductor films. As a general rule, the smaller the circuit elements, the faster the microchip and the more operations it can perform per unit of time. This phenomenal rate of increase in the integration density of the microchips has been sustained in large by advances in optical lithography, which has been the method of choice for producing the microchips.

A higher degree of integration of the circuit requires a shorter wavelength of exposure light used in the method of producing microchips by optical lithography. Changing the exposure light to shorter wavelengths has indeed been the method of choice to increase the resolution. However, switching to shorter wavelengths is becoming increasingly a daunting task as new exposure tools and materials such as phota-resists must be designed. This is a difficult task and it often results in implementation issues and delays. Therefore chip manufacturers generally tend to postpone the introduction of a new exposure wavelength as long as possible and attempt to prolong the lifetime of an existing technology using alternative approaches. Already for a period of time immersion lithography is considered to be an effective method to improve the resolution limit of a given exposure wavelength. Here the air between the bottom lens of the apparatus for producing the microchips and the silicon wafer having a layer of photoresist on top, is replaced with an immersion fluid, leading essentially to a decrease in effective wave length, see for example: A. Takanashi et al. US Patent No. 4480910 (1984). Preferably the fluid has a high transparency at least at the wavelength of the exposure light, does not influence the chemistry of the photoresist on top of the silicon wafer used to produce the microchip and does not degrade the surface of the lens.

Immersion lithography is for example possible for the wavelengths 248 nm, 193 nm and 157 nm. Because of its transparency at 193 nm water is the main candidate for immersion fluid at this wavelength. (See for example: J.H. Burnett, S. Kaplan, Proceedings of SPIE, Vol. 5040, P. 1742 (2003). Because of exceptional transparency of fluorinated and siloxane-based compounds at 157 nm, such fluids are being considered for 157 nm immersion lithography.

Immersion lithography with an immersion fluid comprising an organic or water based solvent with nanosize particles having a higher refractive index than the fluid is described in WO05050324. Water has a refractive index of about 1.44 at 193 nm, which is therefore limited. For further improved immersion lithography an organic based fluid with a refractive index of 1.6 at the applicable wavelength or higher is searched for.

Aim of the invention is to provide an improved method for producing microchips by using immersion lithography using nanosize particles.

Further aim of the invention is to provide an immersion fluid having a high concentration of particles, with low scattering and high refractive index at 248, 193 or 157 nm, preferably 193 nm.

Surprisingly this aim is achieved with an immersion fluid that comprises hybrid particles with an inorganic core of a size of about 9 nm or less, and about 1 nm or more of a metal oxide, nitride, chloride, or fluoride, and organic groups on its surface. Hereinafter, the core of the particles are also denoted as inorganic particles, and the hybrid particles are also denoted as functionalized particles.

In one embodiment, the inorganic particles have a refractive index of about 1.7 or higher, preferably of about 1.9 or higher, and most preferably of about 2.0 or higher at the wavelength intended to be used.

In a preferred embodiment, inorganic particles are used of a material, which material is highly transparent for radiation at the exposure wave length, for example at a wave length of 248, 193 or 157 nm, for example the material having a transmission of about 50% or more, preferably of about 60% or more, even more preferred of about 80% or more as measured over a theoretical light path of 1mm. Absorption in a most preferred embodiment is better than 0.2/cm Which is about 60% transmission for 1 cm path length.

The inorganic particles generally are oxides, nitrides, chlorides or fluorides of metal ions, and/or mixed metal ions. Suitable examples of inorganic nano-particles include, but are not limited to: Aluminium nitride, Aluminium oxide, Antimony pent oxide, Calcium carbonate, Calcium chloride, Calcium oxide, Cerium oxide, Cobalt oxide, Lithium manganese oxide, Lithium titanate, Lithium vanadium oxide, Magnesium oxide, Manganese oxide, Molybdenum oxide, Montmorillonite clay, Niobium oxide, Silicon carbide, Silicon dioxide preferably amorphous silicon dioxide, Silicon nitride, Yttrium oxide, Silicon nitride, Yttrium oxide, Talc, Tin oxide, Titania, Titanium diboride, Titanium dioxide, Tungsten carbide, Tungsten oxide, Vanadium oxide, Yttria, Yttrium oxide, Zinc oxide, Zirconium oxide and Zirconium silicate, and mixed Lu-Al and Y-Al oxides.

In this respect it is noted that a number of the above inorganic compounds may absorb substantially at e.g. 157, 193 or 248 nm as a bulk compound- However, if nm size particles are made from these compounds, the particles can have lower absorption than the bulk particles, due to a so-called quantum effect. Hence, the absorption or transmission preferably is measured at the particles size intended or comparable to the ones to be used.

In a preferred embodiment nano particles comprising an Al³⁺-compound are used in the immersion fluid according to the invention. This is because such an immersion fluid has not only a very high refractive index, but is also highly transparent. Good examples of such particles include Al₂O₃ preferably crystalline α-Al₂O₃ (Sapphire) and γ-Al₂O₃. Further suitable types of Al₂O₃ are mentioned in Z. Chemie. 25 Jahrgang, August 1985, Heft 8, p. 273-280. Also good results are obtained by using nano particles of mixed Al containing oxides like MgAl₂O₄ (spinel), and garnets like yttrium aluminium garnet (YAG) and Lutetium Aluminium Garnet (LuAG). Other preferred particles are nanodiamond and oxides of Be, Mg, Si, Y, Zr, La and Hf and mixed oxides of these elements. Oxides may be replaced by fluorides or chlorides.

In a preferred embodiment, the inorganic particles are ceramic spinels (MgAl₂O₄), silane, germanate, or alumina garnets. Garnets may be described by the formulae's: X₃Y₂Z₃O₁₂ (also called the natural garnets), or X₃Y₅O₁₂ (also called synthetic garnets), In the natural garnets, X may be Magnesium or Calcium (as 2+ ions); Y may be Aluminium, Scandium, Yttrium or Lutetium (as 3+ ions); Z may be Germanium or Silicon (as 4+ ions). In the synthetic garnets, X and Y are different, but can both be chosen from Aluminium, Scandium, Yttrium, or Lutetium. In a preferred embodiment of the invention, Y is Aluminium. Suitable examples of garnets include Mg₃Lu₂Ge₃O₁₂, CaSc₂Mg₂Ge₃O₁₂, CaY₂Mg₂Ge₃O₁₂, CaLu₂Mg₂Ge₃O₁₂, Mg₃Al₂Si₁₂, Mg₃Al₂Ge₃O₁₂, Mg₃Sc₂Ge₃O₁₂, Mg₃Y₂Si₃O₁₂, Mg₃Y₂Ge₃O₁₂, Mg₃Lu₂Si₃O₁₂, Lu₃Al₅O₁₂, Sc₃Al₅O₁₂, Y₃Al₅O₁₂, and Lu₃Sc₅O₁₂.

The average size of the particles is preferably 20 times, more preferable 30 times smaller than the corresponding exposure wavelength, the wave length of the exposure light used in the method according to the invention.

In one embodiment of the present invention, the average size of the nano-particles may be about 9 nanometer (nm) or less, preferably about 6 nm or less, more preferably about 5 nm or less. This results in a high transparency of the immersion fluid, especially at the wave length of the exposure light of 193 nm or 157 nm. The particles may have a minimum size of about 1 nm or higher, preferably about 2 nm or higher. In case the particle are very small, it will be difficult to achieve a high particle loading, in case the particles are too large, transparency may be negatively effected. It should however be noted, that scattering (and thereby the allowable maximum particle size) is influenced by a so-called structure factor. The effect of this factor is stronger at high concentrations of functionalised particles, leading to an increasing transparency (and a decreased scattering) with increasing concentration. Hence, transmission or absorption preferably is measured with the particle size intended to be used, in the concentration intended to be used, and at the wavelength intended to be used

For measuring the dimensions of the nano-particles the particles are in a very dilute mixture applied on a surface in a thin layer, so that at a microscopic (for example FE-SEM (Field Emission Scanning Electron Microscopy) or AFM (atomic force microscopy) or transmission electron microscopy) photographic image of the layer, the single nano-particles are observable. Thereafter, the dimensions are determined from 100 nano-particles which are randomly selected, and the average value is taken. In case of particles having an aspect ratio above 1, like platelets, rods or worm-shaped nano-particles, as the size the distance from one end to the most remote other end is taken.

Preferably, the inorganic particles are spherical or have an ellipsoidal shape, i.e. have an aspect ratio of about 2 or less. The highest concentration, while still being fluid, can be achieved with ellipsoidal particles with aspect ratio of 1.4 - 1.5.

The inorganic particles are used in the immersion fluid with an organic group on the surface. This surface modifications hereinafter also denoted as organic shell. Preferably, the inorganic particle has chemically attached organic groups at its surface. It appears to be important (in order to keep well dispersed low viscosity fluids), to have such a surface modification. Hence, in a preferred embodiment of the invention, a dispersant is bonded to the surface of the inorganic core particle.

In one embodiment of the invention, the organic group is an organic molecule physically attached to the surface, e.g. by van der Waals forces. Such compounds can for example be (low molecular weight) polymers or oligomers, such as for example polyalkanes, polyethers, polysiloxanes and the like. Suitable examples of polyethers are polyethyleneglycol, poly tetrahydrofuran, 1,2-polybutylene glycol and the like. The siloxane polymers, or oligomers, preferably are methyl-siloxanes. Suitable examples of polyalkanens are polyethylene, polypropylene and polybutylene. More preferred are partially or perfluorinated polyalkane oligomers or polymers.

In another - preferred - embodiment of the present invention, the organic group is chemically bonded to the inorganic core particle.

Preferably, the organic group is a hydrophobic group. A preferred hydrophobic group is an alkyl group or an alkyl-nitrile group, both may be fluorinated or perfluorinated.

Preferably, the alkyl group is linear, branched or may comprise a cyclic structure, and may contain 1 or more carbon atoms, preferably 2 carbon atoms or more, and even more preferable, 4 carbon atoms or more. Generally, the alkyl group will contain 30 carbon atoms or less, and preferably contains 20 carbon atoms or less, more preferred 10 carbon atoms or less. The alkylgroup may be fluorinated, or perfluorinated and/or may contain nitril groups. The alkylnitril group may have 1, 2, 3 or 4 nitril groups, preferably 1 or 2, and most preferably,1 nitril group.

It is preferred to have the organic groups forming an organic shell around the inorganic particles, such shell being effective for obtaining a stable dispersion of the particle in a fluid. Apart from stabilizing the particles, the organic shell preferably is small, rather than large. A larger organic shell will lower the refractive index of the immersion fluid, which generally will not be aimed at. The organic shell may be - on average - be about 0.1 nm or larger, preferable about 0.2 nm or larger, and even more preferable about 0.4 nm or larger, as this aids in achieving stable dispersions. Generally, the organic shell will be about 20 nm or smaller, preferably about 10 nm or smaller, and more preferable about 5 nm or smaller, and even more preferable 3 nm or smaller.

It is not critical how to chemically bond the organic groups to the particles. Binding may be done directly, or through a linking group. For example, it may be suitable to have alkylalcohols or carboxylic acid derivatives react with an active surface to form metal-oxide bonds, or it can be feasible to react the particle through a linking agent to a surface active organic group. Carboxygroups may in particular be suitable for 248 nm immersion fluids, as at lower wavelength absorption may be unacceptable.

In one embodiment, the functional particles comprise the inorganic particles (P) that have on their surface a linking group (L), which attaches an organic group (Org) to the particles (P). Preferably, the linking group (L) is a phosphate, sulphate, oxygen, phosphonate or sulfonate group. A linking group may also be derived from zirconate, silane, germanate, and other coupling agents. In one preferred embodiment, the linking group is chosen from one of the metal ions, also present in the inorganic particle. In another embodiment, the linking group comprises sulphur or phosphorous.

Although it may be possible to have an immersion fluid consisting of hybrid particles of the invention, it generally will be preferred to further have some organic fluid (diluent) present. This fluid preferably has a low viscosity, and a relatively low molecular weight. Generally, the molecular weight of the diluent will be about 500 or lower, preferably about 300 or lower, and most preferred about 150 or lower.

In a preferred embodiment of the present invention, the immersion fluid comprises a high amount of hybrid particles and a low amount of organic fluid. Generally, the amount of hybrid particles is about 40 wt% or more. Preferably, the amount of hybrid particles is about 60% by weight or more, preferably about 80 wt% or more, more preferably about 90% by weight or more. It may be useful to have a small amount of organic fluid (or diluent) mixed with the hybrid particles in order to adjust the viscosity and/or to adjust e.g. the refractive index. This may be in particular useful in case the fluid is withdrawn from the lens part of the apparatus, cleaned and recirculated.

Examples of organic fluids are various types of fluids that may have been suggested as immersion fluids per-se, such as for example alkanes, cyclic or multicyclic alkanes, alkane-nitrile, siloxane based fluids or cyclic sulfone and sultone compounds, as well as fluorinated variants from any of the alkane-comprising compounds.

Suitable alkanes used as diluent in the immersion fluid of the present invention preferably comprise 6 carbon atoms or more. The alkanes may comprise 30 carbon atoms or less, preferably about 20 carbon atoms or less, and even more preferred 15 carbon atoms or less. The alkanes preferably comprise one or more ring structures, such as for example decaline, cyclo-octanes, cyclo-dodecanes and the like.

Suitable nitrile group comprising compounds used as diluents in the immersion fluid of the present invention are mono, di or tri-nitrile compounds. Preferred nitrile-group comprising compounds are alkyl-dinitrile compounds having 5 to 16 carbon atoms or branched alkanes with nitrile end-groups. Suitable examples of nitrile compounds include di-nitrile butane, dinitrile-hexane, di-nitrile-octane, di-nitrile-decane and the like.

The volume percentage of the hybrid particles in the fluid is preferable at least 30%, more preferably at least 50%, still even more preferably at least 70%, even still more preferably at least 80%, and most preferably, about 90% or more, as this results in a fluid having a high refractive index, a high transparency and low amount of scattering of the incident light. Generally the volume percentage of the functionalized particles is below 100%, more preferably below 98%.

In one embodiment of the invention, it is preferred that the hybrid particles have a polydispersity index of about 1.1 or higher, preferably of about 1.3 or higher. A polydispersity higher than 1.1 aids in flow characteristics of highly concentrated functionalized particles. Generally, the polydispersity is about 3 or lower, preferably about 2 or lower, as a very high polydispersity has the risk of too large particles that may cause scattering.

In another embodiment of the invention, a mixture of two monodisperse particle sizes is used, such as for example one size chosen in the range of 2-4 nm, and another size chosen in the range of 3-6 nm, the particles being at least 0.5 nm of different size. Particles are understood to be monodisperse if the polydispersity index is about 1.3 or lower, and the particles (if functionalized) crystallize; alternatively, particles are monodisperse if the index is about 1.1 or lower.

The immersion fluids of the present invention not only have favourable optical properties, like a high refractive index and a high transparency, but are also well processable in the standard apparatus for producing microchips. For example the viscosity is low enough, so that the immersion fluid can be pumped easily.

In a preferred embodiment, the immersion fluid is highly transparent for radiation at the intended exposure wave length, for example at a wave length of 248, 193 or 157 nm. The immersion fluid preferably has a transmission of about 50% or more, preferably of about 60% or more, even more preferred of about 80% or more as measured over a theoretical light path of 1mm. Absorption preferably is better than 0.2/cm which is about 60% transmission for 1 cm path length.

The refractive index of the immersion fluid preferably is about 1.6 or higher, even more preferable about 1.7 or higher, and even more preferable about 1.8 or higher.

The viscosity at the operating temperature preferably is about 100 mPas or lower. Generally, the viscosity will be about 5 mPas or higher.

Several methods for the preparation of nano particle dispersions have been described in literature. Some examples are; emulsion precipitation, hydrothermal synthesis, sol-gel processes, sonochemical methods and combustion methods. The preferred method for the synthesis of particles for this invention is hydrothermal synthesis or hydrothermal treatment of precursor particles obtained from another method. Such synthesis methods are well known and described by various authors for many different nano particles. Examples are Yoshimura and Somiya, Mater. Chem. Phys, 1999, vol 61, p1-8, and Tadafumi Adschiri, Seiichi Takami, Takao Tsukada, Materials Science and Technology, 40, (2003), 96-100

As explained above the chemistry of the particle core, the functionalized particle surface and the dispersion medium are important factors. In order to achieve a high transparency of the immersion fluid, it is also important to prevent contamination of the system, which in particular may occur at high temperatures.

In a preferred embodiment of the invention, contamination, in particular metal ion contamination is less than 1 ppm. In order to achieve low contamination levels, it is preferred to use uncontaminated raw materials. Further, reaction time is kept as short as possible. Therefore, preferred methods are continuous processes where the contact time between the fluid and the reactor surface is minimized. Further improvement can be achieved by coating all internal parts with an inert ceramic coating, of which an example is the silonite coatings of Entech Instruments Inc.

In a further embodiment of the invention, the particles are further treated to yield an immersion fluid with an absorption of about 0.2 or less per cm path length. Suitable ways of further treatment are crystallisation, in case the particles are monodisperse, or dialysis against e.g. the pure liquid part of the immersion fluid.

In one embodiment of the invention, the inorganic particles are prepared by hydrothermal treatment. The hydrothermal treatment is used either in the synthesis of the particles from precursors or applied to the already available particles.

In a preferred embodiment, the particles are prepared in a continuous, or 'in-line' thermal treatment. Continuous or in-line is defined as reacting the raw materials through a flow reactor, resulting in a relatively short, and well defined time of reaction. This is to be contrasted to autoclave reactions, where the raw materials are combined in one pot, which is brought up to a certain temperature and pressure, and thereafter cooled. Such 'one pot' synthesis may take hours, and the actual reaction time under e.g. supercritical conditions may be difficult to ascertain precisely, In contrast, a continuous or in-line thermal treatment allows short and defined processing periods. It is particularly preferred to use in-line thermal treatment with supercritical water. If the water with the metal-oxide salts is brought in a supercritical state, the metal compound crystallises very fast into small particles that remain small because the solubility of the salts in supercritical water is very low and further crystallisation to larger particles is therefore hindered. Hence, the hydrothermal treatment preferably is carried out at a temperature of above 374 °C and at a pressure above 22.1 MPa. Particularly preferred is a temperature of about 380 °C or higher, and a pressure of about 30 MPa or higher. Generally, a temperature of about 650 °C or lower is used, and a pressure of about 60 MPa or lower. It may be further useful to vary the pH to optimize solubility and crystal size. The pH may be about 0 or higher, preferably about 1 or higher. The pH may be about 13 or lower, preferably about 12 or lower, and even more preferred, about 10 or lower; (the pH is defined as the pH measured at 25 °C).

In a further embodiment of the invention, reagent gasses causing oxidation or reduction are supplied during the hydrothermal treatment. Useful gasses are for example hydrogen gas, oxygen gas or hydrogen-peroxide.

The particles of the immersion fluid of the present invention are further treated to have an organic shell. It is preferred to react the inorganic particles in-line after formation, with a functionalization agent. It may be useful, to first exchange the water as a solvent or dispersion agent, to an organic solvent, like decaline, cyclohexane, toluene, or the like. As the hydrothermal treatment in supercritical water is very high (generally above 400 °C), the reaction mixture may need to be cooled before exchange of solvent, and/or functionalization. It may be preferred to execute the modification under supercritical conditions if suitable, such as for example described in Journal of Material science, vol 41, March 2006, pp 1445-1448.

If necessary, cooling may take place by letting the reaction mixture flow into a solution with reactants, or by cooling over a heat-exchanger, or the reaction mixture can be in-line mixed with further raw materials to achieve a desired reaction.

As explained above, it is preferred that the reactor and the connective pipes are internally coated with a ceramic coating, or other coating that precludes foreign metals to contaminate the particles.

It is even more preferred to make functionalised nano particles with a hydrothermal treatment method to obtain stable dispersions of the nano particles in the solvent used in the immersion fluid and a small amount of water. In this way grafting of the organic group, and formation and densification of the particle can be done in the same step. This has as further advantage, that the functionalizing groups hinder the further crystallisation and growth of the particles, and supercritical conditions are not necessary for making particles small enough.

The present invention also relates to a method for the production of microchips while using immersion lithography, wherein the immersion fluid is an immersion fluid according to the above described embodiments of the present invention.

In a preferred embodiment the method according to the invention the method further comprises the steps of:
a) measuring the refractive index of the immersion fluid directly or indirectly,
b) adjusting the refractive index of the immersion fluid at a predetermined value by adding extra, a fluid or adding functionalized particles to the immersion fluid.

In this way fluctuations in the refractive index due to variations in temperature and concentration of the additive are compensated for.

The refractive index may be measured as such directly. It is also possible to measure one or more other parameters, being a measure for the refractive index. In case the immersion fluid comprises the transparent particles and the additive in an amount, such that the refractive index of the fluid comprising the additive is equal to the refractive index of the transparent particles, it is possible to determine the light scattering of the transparent particles and to add pure fluid or additive to reduce the light scattering. The addition of extra pure fluid may suitably be carried out by mixing extra pure fluid with the immersion fluid. The addition of extra additive may suitably be carried out by mixing a concentrated solution or dispersion of the additive in the pure fluid with the immersion fluid.

A still further preferred embodiment of the method according to the invention comprises the steps of
a) transporting the immersion fluid after being used in the production of a microchip to a cleaning unit,
b) cleaning the immersion fluid
c) recycling the cleaned immersion fluid into the process for producing the chips.

Due to the extraction of components from the photoresist layer on top of the wafer, possible chemical changes in the fluid components during the exposure step and further reasons, the immersion fluid will tend to be contaminated. This means that after a certain period of using the fluid in the process of the present invention, the fluid has to be refreshed. However this increases fluid consumption and negatively influences the process economics. Surprisingly it is possible to clean the fluid and recycle the cleaned fluid into the process of the present invention.

Cleaning of the fluid is suitably carried out by cross flow filtration or dead end flow filtration using for example membranes for microfiltration, ultrafiltration, nanofiltration or reverse osmoses. Good results are obtained if a stirred pressure cell is used. Another way of cleaning is by liquid-liquid extraction. Particles stabilised with alkanes and dispersed in an alkane based liquid can be washed with nitriles like acetonitrile or water because both phases do not mix. Alternatively, particles stabilized with sulphonic acids, nitriles or phosphate groups can be washed with alkanes like decalin.

Preferably the immersion fluid has a transmission at one or more wavelength out of the group of 248, 193 and 157 nm of at least 60% through a path-length of 1 mm, more preferably at least 80%, still more preferably at least 90%, even still more preferably at least 95%.

## Claims

1. immersion fluid for use in immersion lithography, wherein the immersion fluid comprises hybrid particles with an inorganic core of a size of about 9 nm or less, and of about 1 nm or more, of a metal oxide, nitride, chloride, or fluoride, and having organic groups on the surface of the inorganic core.

2. Immersion fluid according to claim 1, wherein that the refractive index of the inorganic core is at least 1.7 at the intended wavelength.

3. Immersion fluid according to any one of claims 1 - 2, wherein the organic groups are physically bonded to the surface of the inorganic core.

4. Immersion fluid according to any one of claims 1 - 2, wherein the organic groups are chemically bonded to the surface of the inorganic core.

5. Immersion fluid according to claim 4, wherein the particles are functionalized through a phosphate, silane or sulphate group.

6. Immersion fluid according to any one of claims 1 - 5, wherein the particles have an organic group chosen from an alkyl group, fluorinated alkyl group, alkylnitril or fluorinated alkylnitril group.

7. Immersion fluid according to anyone of claims 1 - 6, wherein the immersion fluid comprises about 40 volume % or more of the hybrid particles.

8. Immersion fluid according to any one of claims 1 - 7, wherein the immersion fluid comprises particles having an inorganic core of about 2 nm or more and about 6 nm or less.

9. Immersion fluid according to any one of claims 1 - 8, wherein the nano particles have an inorganic core with an average size that is 30 times smaller than the wavelength of the exposure light.

10. Immersion fluid according to any one of claims 1 - 9, wherein the exposure wavelength is about 248, 193 or 157 nm.

11. Immersion fluid according to any of claims 1 - 10, wherein the fluid comprises about 80 volume % or more of the functionalized nano particles about 20 volume% or less of a diluent.

12. Immersion fluid according to any of claims 1 - 11, comprising hybrid particles, wherein the immersion fluid has a transmission of at least 60%, as measured over a theoretical light path of 1 mm.

13. Immersion fluid according to any one of claims 1 - 12, wherein nano particles comprising an Al³⁺-compound are used.

14. Immersion fluid according to claim 13, wherein nano particles of fused LuAlGarnet, MgO, nanodiamond, MgAl₂O₄ or nano particles comprising a mixture of fused amorphous SiO₂ and Al₂O₃ are used.

15. Immersion fluid according to any one of claims 1-14, wherein the shell has a diameter of about 0.2 nm or more, and about 10 nm or less.

16. Immersion fluid according to any one of claims 1 - 15, wherein the immersion fluid contains as diluent, an alkane having 4-20 carbon atoms optionally further being fluorinated, perfluorinated and/or containing one or more nitrile groups

17. Method for the production of microchips while using immersion lithography, wherein the immersion fluid is an immersion fluid according to any one of claims 1 - 16.

18. Method according to claim 17, **characterised in that** the method further comprises the steps of
a) transporting the immersion fluid after being used in the production of a microchip to a cleaning unit,
b) cleaning the immersion fluid
c) recycling the cleaned immersion fluid into the process for producing the chips.

19. Method according to claim 18, wherein the method further comprises the step of measuring the refractive index of the recycled fluid and adjusting a deviation - if necessary - of the recycled fluid by adding liquid or functionalized particles.

20. Method for making nanosized particles, suitable for an immersion fluid according to any one of claims 1 - 16 wherein the nanoparticles are prepared with hydrothermal treatment.

21. Method according to claim 20, wherein the hydrothermal treatment is performed in a continuous process.

22. Use of an immersion fluid according to any one in claims 1-16 in an immersion fluid microchips fabrication apparatus.
